# EUROPEAN PATENT APPLICATION

(11) **EP 3 882 646 A1**
(43) Date of publication of application: **22.09.2021**
(21) Application number: 20163834.3
(22) Date of filing: 18.03.2020
(51) Int. Cl.: G01R 33/09, G01R 33/022, G07D 7/04, G01R 33/04

(54) **INTEGRATED MAGNETOMETER AND METHOD OF DETECTING A MAGNETIC FIELD**

(71) Applicant: TE Connectivity Germany GmbH, 64625 Bensheim (DE)
(72) Inventor: MEISENBERG, Armin, 44227 Dortmund (DE); BARTOS, Axel, 45731 Waltrop (DE)
(74) Representative: Grünecker Patent- und Rechtsanwälte PartG mbB

(57) **Abstract**

The present invention relates to an integrated magnetometer and to a method of detecting a magnetic field. In particular, the present disclosure relates to a sensor for detecting ferro- or superparamagnetic structures on material surfaces. The integrated magnetometer (600) comprises at least one field sensor unit (604, 606) comprising a first transducer element (R_{H1}, R_{H2}; R_{H3}, R_{H4}) for generating, in response to a detected magnetic field, a first electrical output signal, and at least one gradient sensor unit (608, 610) comprising at least a pair of second transducer elements (R_{G1}, R_{G2}; R_{G3}, R_{G4}) which are arranged to detect the magnetic field at two different locations and to generate, in response to the detected magnetic field, a second electrical output signal, wherein said first and second transducer elements are formed on a common substrate (616) and are encompassed by a common protective layer and/or housing (618).

## Description

The present invention relates to an integrated magnetometer and to a method of detecting a magnetic field. In particular, the present disclosure relates to a sensor for detecting ferro- or superparamagnetic structures on material surfaces.

Highly sensitive magnetometers are for instance required to detect the very weak magnetic material contained in some magnetic security features of a banknote when preforming a security check of the banknote. These security features may for instance comprise magnetic pigments in the printing color pigments, but also metallized safety threads, in any case specifically designed magnetic features. Due to their high sensitivity and low noise, anisotropic magnetoresistance (AMR) sensors may be used for this purpose. However, the electrical signals generated are still very weak.

In the past, the banknote line sensor arrays had a reading width of approximately 10 mm per channel. Now there are efforts on the market to increase the resolution in order to be able to resolve more magnetic details on the banknotes. Smaller magnetic security features are expected due to the increasing number of counterfeit banknotes and improved note quality among counterfeiters. With a higher resolution of the magnetic image of a banknote, the verification of the features of course has to be much more accurate.

For example, a banknote validator system may require 112 channels with a total scan length of 196 mm. This corresponds to a resolution of 1.75 mm per channel.

Generally, magnetoresistive sensors (also referred to in this application as magnetic sensors) measure the direction and intensity of magnetic fields. Such arrangements and methods find use in the art of determining magnetic materials such as magnetic markings in banknotes, but also detecting angles and positions by means of magnetometers.

The sensors make use of the magnetoresistive effect, which is the tendency of a material (e. g. ferromagnetic) to change the value of its electrical resistance in an externally applied magnetic field. In particular, in multicomponent or multilayer systems, giant magnetoresistance (GMR), tunnel magnetoresistance (TMR), colossal magnetoresistance (CMR), and extraordinary magnetoresistance (EMR) are observed, while the anisotropic magnetoresistive effect (AMR) needs only one layer to occur.

Magnetic sensors provide an outstanding accuracy as well as a high robustness against challenging environmental conditions and play an important role in various applications such as manufacturing and transportation applications. In more detail, sensors based on a magnetoresistance effect are important components because of their low intrinsic measurement error and high stability. Additionally, the favorable temperature characteristic as well as the robustness against harsh environmental conditions leads to the relevance of magnetoresistive sensors in many important applications.

The strength of the magnetic field is usually described by the magnetic flux density B. The gradient of the magnetic flux density results from a change of B per unit distance along the direction of the greatest change of B. As B is a vector, which usually is also a function of all three spatial dimensions, the gradient is a tensor comprising all partial derivatives of the three spatial B-field components with respect to the spatial coordinates. In practice, for measuring the gradient two magnetic field sensors are used which measure the magnetic flux density at two different locations, separated by a well-defined distance. Then, the difference of the two measured flux density values is calculated and divided by the distance. The distance is chosen in a way that the B-field varies linearly within the distance, in other words, by choosing a distance that is small compared to the distance between each of the sensors and the magnetic field source.

When reading magnetic safety structures on documents such as banknotes with conventional magnetoresistive sensor arrays, it is known to either detect the intensity of the magnetic field as an absolute value or to detect a local field gradient. For each technology there exist different sensor designs. Field sensors which detect the absolute intensity of the magnetic field have the advantage of a high sensitivity especially over higher distances. However, field sensors have the disadvantage that their output signal may be impaired by external disturbing magnetic fields.

On the other hand, gradient sensors preform a differential measurement and are therefore insensitive to external disturbing magnetic fields. However, gradient sensors have the disadvantage of a much lower sensitivity compared to field sensors, in particular for larger distances from the magnetic objects to be detected.

Known banknote sensors therefore require a choice between these two concepts and the acceptance of the respective disadvantages.

At least one of the above outlined objectives is solved by the subject matter of the independent claims. Advantageous embodiments of the present invention are the subject matter of the dependent claims.

In this disclosure, an electronic design is provided for a low field AMR or one of the other magnetoresistive effects, e. g. a tunnel magnetoresistance (TMR) sensor. A TMR sensor can be realized together with an application specific integrated circuit (ASIC), and results in a significantly improved sensitivity. The integrated magnetometer according to the present disclosure combines a gradient sensor and a field sensor on one sensor chip. This solution allows the measurement of a high-resolution field signal and a gradient signal whose integral provides a reconstructed field signal with lower resolution but without interference. The advantages of both operating modes can thus be used together without the respective disadvantages.

In particular, the present disclosure provides an integrated magnetometer comprising at least one field sensor unit comprising a first transducer element for generating, in response to a detected magnetic field, a first electrical output signal, and at least one gradient sensor unit comprising at least a pair of second transducer elements which are arranged to detect the magnetic field at two different locations and to generate, in response to the detected magnetic field gradient, a second electrical output signal. The first and second transducer elements are formed on a common substrate and are encompassed by an integral protective housing.

The concept allows for and optimized signal quality and information retrieval. Furthermore, the integration of a field sensor in a gradient sensor does not increase the space requirement and thus the chip cost of the gradient sensor. No different sensor types are required for field and gradient measurement. This simplifies and reduces the cost of sensor production, warehousing, and logistics.

Advantageously, the first transducer element and/or the pair of second transducer elements comprise at least one magnetoresistive element. As mentioned above, magnetoresistive elements have the advantage of providing a low intrinsic measurement error, a high sensitivity, and high stability. Additionally, they have a favorable temperature characteristic as well as robustness against harsh environmental conditions. Furthermore, magnetoresistive elements can be connected to form voltage dividers or Wheatstone bridge topologies for extracting the electrical signal and for compensating temperature effects.

Advantageously, the transducer element arrangement responding to homogeneous fields is placed in the space between the two transducer elements which form the sensing arrangement sensitive to local field differences. Thus, no additional space is needed compared to a conventional gradient sensor. Moreover, a particularly accurate measurement can be performed when correcting the output signal of the field sensor using the output signal of the gradient sensor.

In order to be able to discern more than one magnetic feature at a time, the integrated magnetometer advantageously is able to output more than one channel. To achieve such a multichannel measurement, the at least one first transducer element is arranged between the two second transducer elements of the at least one pair of second transducer elements, the first and second transducer elements being aligned to form a first transducer group, and at least one further transducer group is arranged on the common substrate. Each group corresponds to one output signal channel.

According to an advantageous embodiment, the first transducer element comprises two magnetoresistive elements, which are positioned adjacent to each other and which are electrically connected to form a half bridge. The circuit topology of a half bridge has the advantage that it can be completed to form a full bridge by additional constant resistors so that the measurement signal can be derived from the bridge voltage. Such measuring bridges have high sensitivity and accuracy.

In the same manner, the two second transducer elements of the at least one gradient sensor unit may comprise one magnetoresistive element each, which are positioned distanced from each other and are electrically connected to form a half bridge.

According to a further advantageous example of the present disclosure, the magnetometer comprises a plurality of terminals for connecting the integrated magnetometer to external components, wherein first terminals are connected to the field sensor unit and second terminals are connected to the gradient sensor unit, and wherein the first terminals are arranged in a pattern corresponding to a pattern of the second terminals turned by 180 degrees around a central axis of the substrate. In other words, the pin assignment of the sensor housing can be selected so that when using only one operating mode, it is possible to choose between the operating modes by soldering to the PCB rotated through 180 degrees. This allows a simplification of the fabrication and stock keeping because only one type of chip is able to fit into three completely different measurement architectures.

According to a further advantageous example, the housing is a surface-mount technology, SMT, compatible housing. Surface-mount technology (SMT) is a method for producing electronic circuits in which the components are mounted or placed directly onto the surface of circuit carriers, e. g. printed circuit boards (PCBs). An electronic device so made is called a surface-mount device (SMD). In industry, it has largely replaced the through-hole technology construction method of fitting components with wire leads into holes in the circuit board. Both technologies can be used on the same board, with the through-hole technology used for components not suitable for surface mounting such as large transformers and heat-sinked power semiconductors. An important advantage of SMT in manufacturing includes reduced board cost, reduced material handling costs, and a controlled manufacturing process. Routing of traces is reduced, the size of the board is reduced, and the number of drilled holes is also reduced. In connection with the present disclosure, SMD housings are mainly used because of their small and flat dimensions, resulting in a small distance between the chip surface and the object to be measured. Furthermore, SMD components can be positioned particularly accurate and with small distances between each other. This is advantageous for achieving a seamless reading along a linear array of sensors.

Advantageously, the substrate further comprises electronic components for protecting the sensor and/or electronic components for performing signal processing. By such an additional degree of integration, the space requirement is reduced and the accuracy can be enhanced.

The present invention further relates to a method of detecting a magnetic field using at least one integrated magnetometer according to the present invention, wherein the method comprises the following steps:
measuring a magnetic field strength at a first position of the integrated magnetometer and generating an absolute output signal;
simultaneously, measuring the magnetic field strength at a second and a third position of the integrated magnetometer and calculating a differential signal;
evaluating the absolute signal and the differential signal to generate a combined output signal.

According to an advantageous example of the present invention, the magnetic field to be detected is movable with respect to the integrated magnetometer. For instance, the present invention can be used with an authentication system for banknotes or other documents, where magnetic safety features on the banknotes (or other documents) are detected by means of a scanner. Of course, the present disclosure may also be used in a lot of other application environments, such as position sensing, current sensing, flow sensing and metering, or any other application where an accurate detection of the magnetic field is needed. Other applications of the present invention can be seen in the field of material inspection, for instance magnetic crack detection in metallic (not necessarily ferromagnetic) materials. Sensor arrays for magnetic crack detection may comprise an integrated pre-magnetizing magnet which generates eddy currents in electrically conductive metallic materials. These eddy currents are influenced by defects so that in turn the magnetic field is changed and a flaw can be detected by a magnetic sensor.

Moreover, the present invention can advantageously be used for other material testing purposes. For instance, such lines of magnetic sensors can generally be used to detect ferromagnetic or electrically conductive objects, for example metal particles in food or metal objects in letters (letter bombs). Also the detection of magnetic particles (microbeads) in biology, medicine, or analytics is possible with this system.

Furthermore, the absolute signal and the differential signal can be compared with each other to generate a quality signal indicative of the quality of the measurement. In this manner, for instance the presence of disturbing external magnetic fields, or a non-optimal installation of the magnetometer can be detected and removed. In particular, according to an advantageous example of the present disclosure, the combined output signal is a reconstructed field signal which is corrected by cancelling interferences.

As mentioned above, the magnetic field to be detected may be generated by a magnetic safety feature of a document. In such a case it is advantageous to detect not only one but more safety features simultaneously. This can be achieved by providing a plurality of groups formed by first and second transducer elements to measure a plurality of signal channels.

This high level of integration makes it for instance possible to implement high-resolution line sensors at the smallest producible installation space. This is an important step for the next generation of linear sensor arrays for applying in banknote, level, and linear applications. In addition, this approach is readily applicable to the next generation of TMR sensors, which have higher sensitivity, a higher resistance (less power consumption), and can be deposited right on the ASIC.

The accompanying drawings are incorporated into the specification and form a part of the specification to illustrate several embodiments of the present invention. These drawings, together with the description, serve to explain the principles of the invention. The drawings are merely for the purpose of illustrating the preferred and alternative examples of how the invention can be made and used, and are not to be construed as limiting the invention to only the illustrated and described embodiments.

Furthermore, several aspects of the embodiments may form-individually or in different combinations-solutions according to the present invention. Further features and advantages will become apparent from the following more particular description of the various embodiments of the invention as illustrated in the accompanying drawings, in which like references refer to like elements, and wherein:
- **FIG. 1**: is a schematic diagram illustrating the operation of a magnetic gradient sensor;
- **FIG. 2**: is a schematic diagram illustrating the operation of a magnetic field sensor;
- **FIG. 3**: is a schematic diagram of a two channel magnetic gradient sensor;
- **FIG. 4**: is a schematic diagram of a conventional three channel magnetic gradient sensor;
- **FIG. 5**: is a schematic diagram of a conventional three channel magnetic field sensor;
- **FIG. 6**: is a schematic layout diagram of an integrated magnetometer according to the present disclosure;
- **FIG. 7**: is a circuit diagram of the integrated magnetometer shown in Fig. 6;
- **FIG. 8**: is a schematic diagram illustrating the field sensing operational mode of the magnetometer shown in Fig. 6;
- **FIG. 9**: is a schematic diagram illustrating the gradient sensing operational mode of the magnetometer shown in Fig. 6.

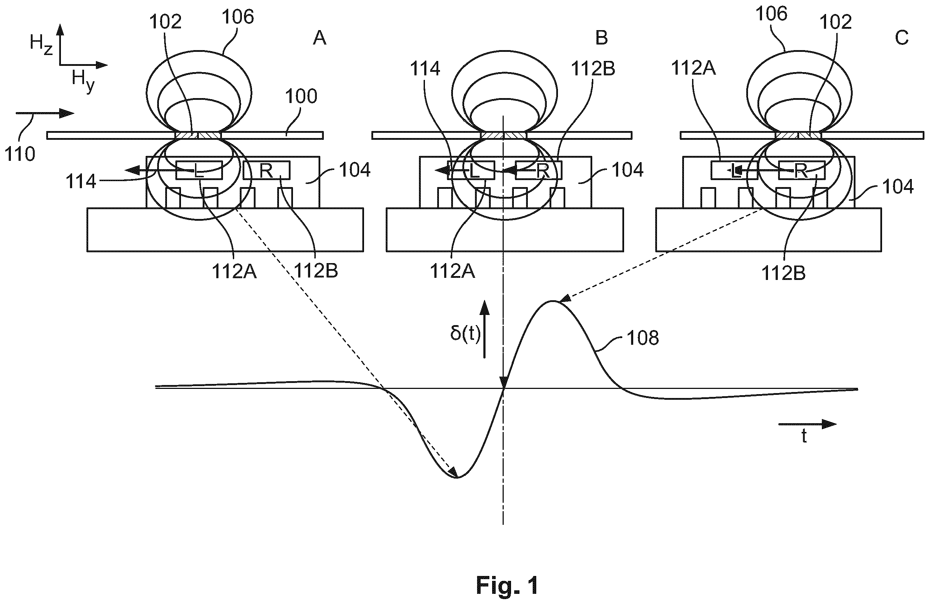

The present invention will now be explained in more detail with reference to the Figures. Referring to Fig. 1, a schematic diagram of the detection of a moving (ferro-) magnetic marking on a banknote by means of a magnetic gradient sensor is shown. In particular, a banknote 100 with a magnetic safety feature 102 moves with respect to a magnetic gradient sensor 104. The safety feature 102 is generally referred to as a magnetic field source with a north and south pole and magnetic flux lines 106. As mentioned above, the magnetic source 102 may be attached to any other movable object for different measurement applications, e. g. determination of a position. However, in the following the scenario of a banknote authentication system will be explained as an example of how the integrated magnetometer according to the present invention works and can be used.

The diagram of Fig. 1 shows as a curve 108 the measurement signal δ as a function of the time t. In particular, δ(t) is the difference between the measurement values of two transducer elements 112A, 112B. Illustrations A, B, and C show respective positions of the magnetic source 102 with respect to the magnetic gradient sensor 104 at specific instants while the banknote 100 is moving in the direction of the arrow 110. Without loss of generality, this direction is assumed to be along the y-direction, whereas the banknote 100 is distanced apart from the magnetic gradient sensor 104 in the z-direction. The directions of the corresponding Cartesian magnetic field components H_{y} and H_{z} are schematically indicated in Fig. 1.

For instance, the banknote 100 may be moving in the direction 110 with a velocity of 1 m/s to 10 m/s. The magnetic gradient sensor 104 has two transducer elements 112A, 112B. Each of the transducer elements 112A, 112B detects a magnetic flux in the y-direction. When the magnetic source 102 is in the position A shown in Fig. 1, a maximal difference is measured in the negative direction because only transducer element 112A, which is on the left side of the magnetic gradient sensor 104, measures a magnetic flux as indicated by arrow 114.

When the banknote 100 containing the magnetic source 102 moves further in the direction 110, the measurable magnetic flux for the left-hand transducer element 112A becomes smaller, whereas the measurable magnetic flux for the right-hand side transducer element 112B increases. Because the measurement signal δ(t) represents the difference between the signals of the two transducer elements 112A and 112B, the configuration for positon B, where the magnetic source 102 is symmetric with respect to the transducer elements 112A, 112B, results in a zero signal.

Finally, a further (positive) maximum of the curve 108 can be seen for position C, where the right-hand side transducer element 112B is in closest proximity to the magnetic source 102.

The advantage of such a gradient measurement is the fact that inherent to the differential measurement disturbing magnetic fields do not impair the accuracy of the measurement. However, the signal amplitude is lower than for magnetic field sensors which detect the absolute value of the flux density.

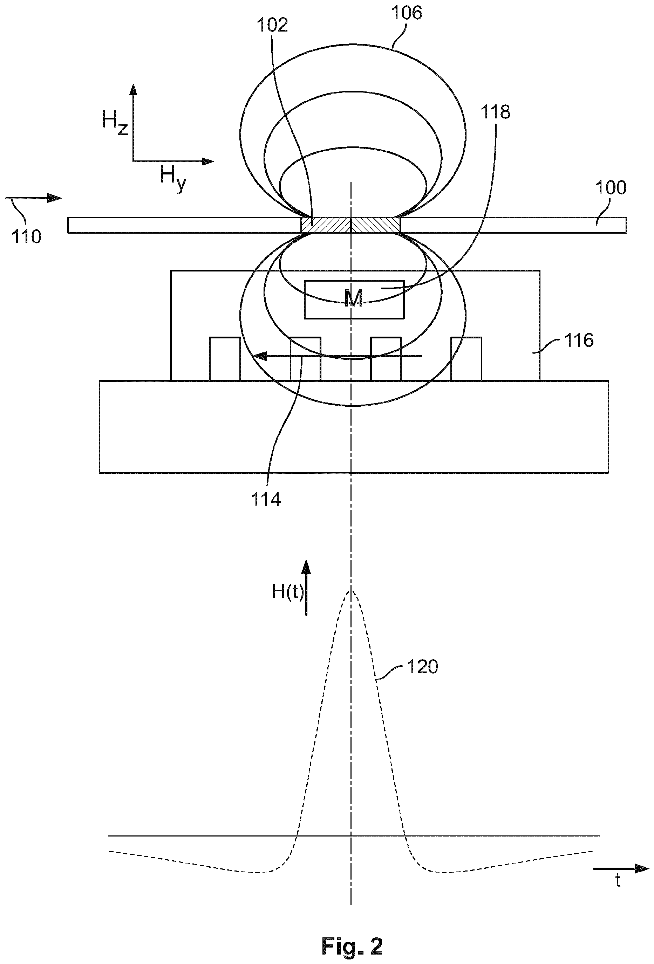

Fig. 2 illustrates a banknote authentication system (corresponding to the system shown in Fig. 1) having a magnetic field sensor 116 instead of the magnetic gradient sensor 104. The magnetic field sensor 116 has only one transducer element 118 which outputs a signal H(t) which is indicative of the absolute value of the magnetic flux in the y-direction. Curve 120 shows the progression of the signal with the time t while the banknote 100 is moving along the direction 110. As can be seen from the comparison with Fig. 1, the measurable signal amplitude is higher. However, a problem with magnetic filed sensors is that they are sensitive towards disturbing magnetic fields which directly influence the measurement signal.

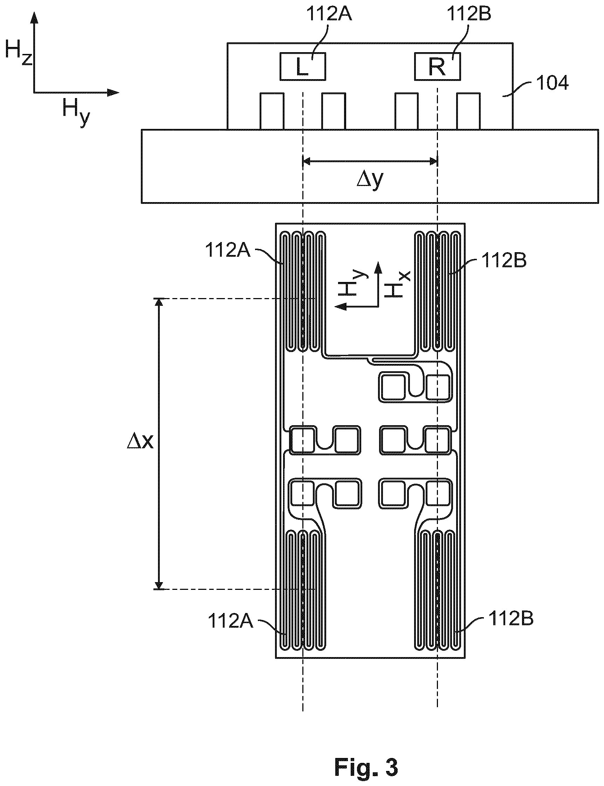

Furthermore, Fig. 3 illustrates another aspect of the magnetic gradient sensor shown in Fig. 1. In Fig. 3 the top view onto the magnetic gradient sensor 104 is shown together with the side view according to Fig. 1. The distance between the first and second transducer elements 112A and 112B is denoted by Δy. The distance Δy limits the resolution of the gradient sensor in the scan direction, i. e. the direction 110 (see Fig. 1) in which the banknote 100 moves.

In the shown example, there is not only one pair of transducer elements 112A and 112B, but a second pair of transducer elements 122A and 122B. The distance Δx between the transducer elements 112 and 122 determines the minimal lateral resolution between two magnetic features which are arranged along the x-direction. The output signals of the two pairs of transducer elements 112, 122 form channels, each channel containing the information about a particular region in the x-direction.

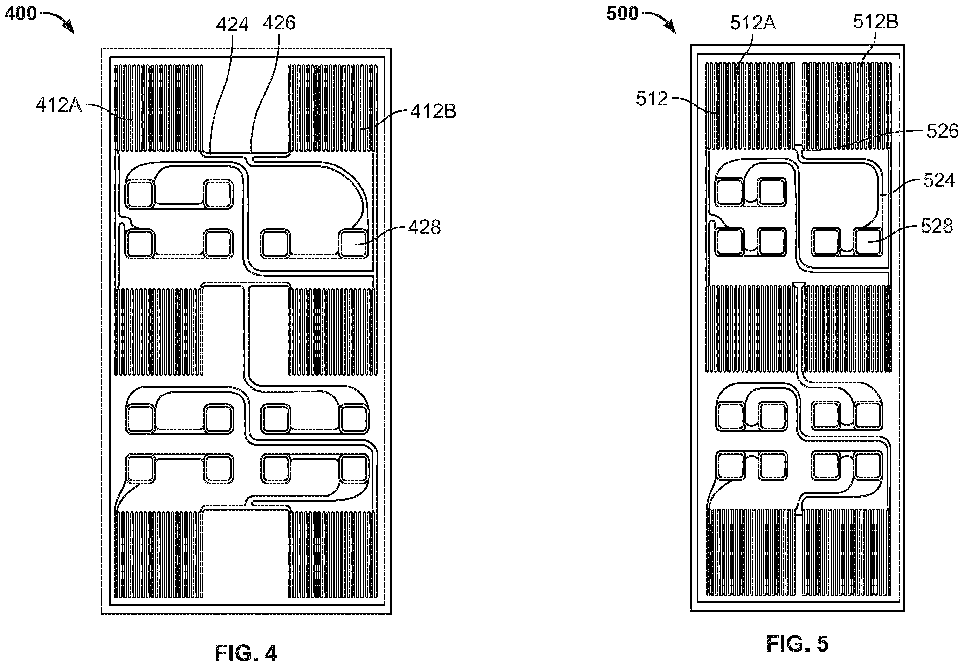

Of course, the amount of channels is not limited to one or two, also three channels or more are possible. Fig. 4 and 5 illustrate examples of three-channel magnetic sensors. In particular, Fig 4 shows a three-channel magnetic gradient sensor 400. The magnetic gradient sensor 400 comprises three pairs of transducer elements 412A, 412B. Each pair of transducer elements 412A, 412 B is connected in series by means of electrically conductive leads 424. At the connecting line between the first and second transducer elements 412A, 412B a central node 426 is connected to contact pads 428. Via the contact pads 428, the central node 426 may be connected to signal processing components (not shown in the Figures). In particular, the differential signal is generated for each pair of transducer elements as explained above with reference to Fig. 1.

Fig. 5 illustrates a three-channel magnetic field sensor 500 according to the principle explained with reference to Fig. 2. It has to be noted that the transducer element 512 may be formed as a pair of magnetoresistive elements 512A, 512B. These magnetoresistive elements 512A, 512B are arranged directly adjacent to each other, so that they essentially experience the same magnetic flux at any given time. Unlike in Fig. 4 , where both resistors 412A and 412B react in the same way to an external field, resistors 512A and 512B are designed to react to a homogeneous field with opposite resistance changes, so that a homogeneous magnetic field across both resistors in this case causes a strong output signal from the voltage divider arrangement.

When using AMR magnetoresistive elements, such opposing reaction of the two resistors can be achieved by providing a different tilting direction of the barber poles arranged on the nickel iron strips. In case of GMR and TMR elements, different pinning directions of the pinned layers are used.

From a signal evaluation standpoint, the magnetoresistive elements 512A, 512B may also be treated as a half-bridge (or voltage divider). At the connecting line between the first and second transducer elements 512A, 512B a central node 526 is connected via electrically conductive leads 534 to contact pads 528. Via the contact pads 528, the central node 526 may be connected to signal processing components (not shown in the Figures)

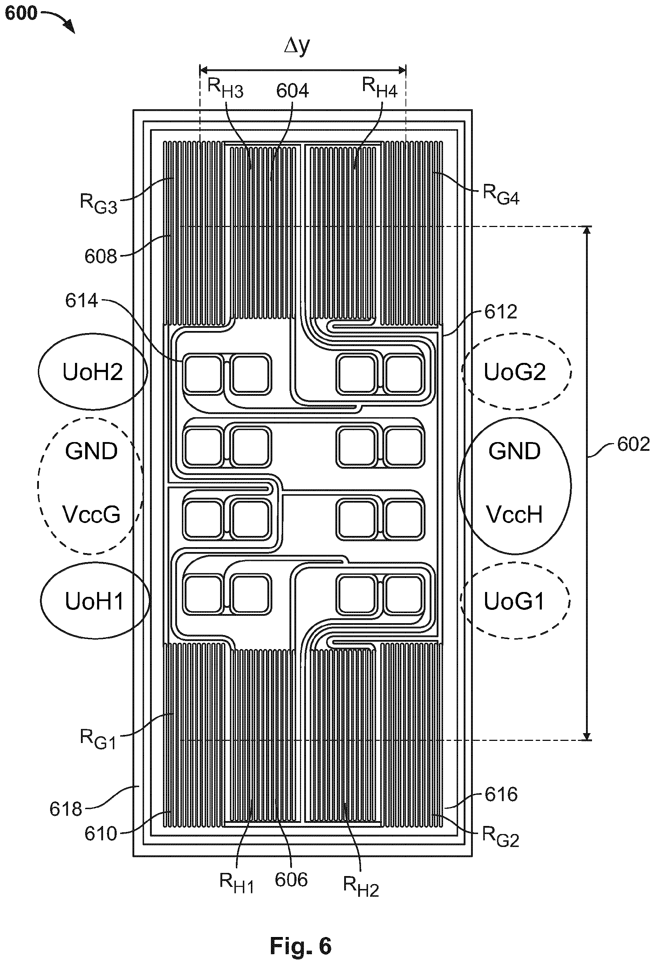

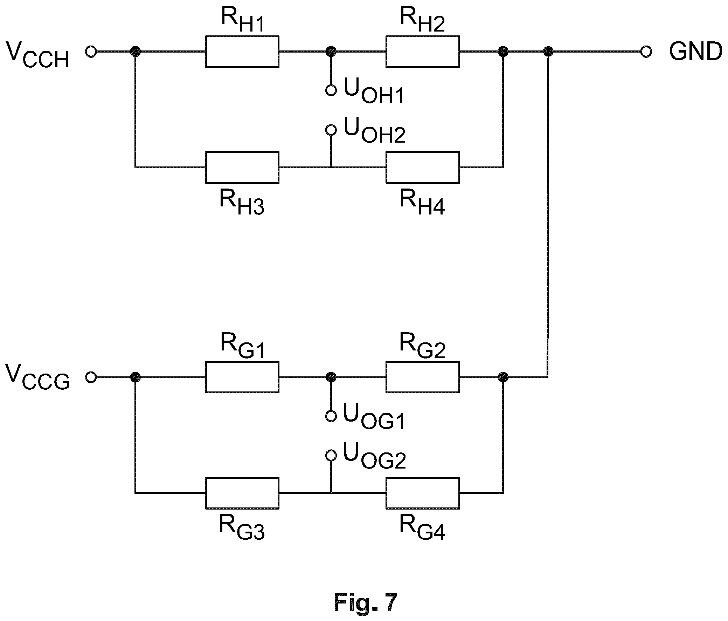

The arrangements shown in Fig. 4 and 5, however, have the drawbacks explained above and inherent to using separate chips for measuring either the magnetic gradient or the magnetic field. In contrast thereto, with reference to Figures 6 and 7 an improved magnetometer 600 according to the present invention will be explained.

Fig. 6 illustrates the layout of an integrated magnetometer 600 according to the present invention, combining the advantages of magnetic gradient sensing and magnetic field sensing on one integrated chip with a common substrate, and overcoming the problems of known magnetic sensors. Fig. 7 shows the corresponding equivalent circuit diagram of the integrated magnetometer 600.

The integrated magnetometer 600 is designed for detecting a two channel magnetic feature with the two separate parts of the feature being distanced apart by a channel distance 602. The channel distance 602 may for instance be 1.75 mm. The integrated magnetometer 600 comprises, for each of the two channels, a magnetic field sensor 604, 606, which comprises as transducer elements two magnetoresistive elements R_{H1}, R_{H2} and R_{H3}, R_{H4}, respectively. The two magnetoresistive elements R_{H1}, R_{H2} of the first magnetic field sensor 604 are arranged closely adjacent to each other, and the two magnetoresistive elements R_{H3}, R_{H4} of the second magnetic field sensor 606 are arranged closely adjacent to each other. Thus, the magnetoresistive elements of each magnetic field sensor experience essentially the same magnetic flux to be measured. The voltage measured at the terminal U_{oH1} can evaluated for generating a first output signal indicative of the absolute value of the magnetic field strength.

Furthermore, the integrated magnetometer 600 comprises, for each of the two channels, a magnetic gradient sensor 608, 610, which comprises two magnetoresistive elements R_{G1}, R_{G2} and R_{G3}, R_{G4}, respectively. The two magnetoresistive elements R_{G1}, R_{G2} of the first magnetic gradient sensor 608 are arranged distanced apart from each other by a distance Δy, and the two magnetoresistive elements R_{G3}, R_{G4} of the second magnetic field sensor 610 are also arranged distanced apart from each other by the distance Δy. Thus, the magnetoresistive elements of each magnetic gradient sensor work as a gradient sensor as explained above referring to Fig. 1. The voltage measured at the terminal U_{oG1} can evaluated for generating a second output signal indicative of the gradient of the magnetic field strength. Advantageously, when forming a differential output signal, this output signal using the magnetoresistive elements R_{G1}, R_{G2} and R_{G3}, R_{G4}, respectively, is not impaired by the presence of disturbing external magnetic fields. On the other hand, the strong first output signals of the magnetic field sensors 604, 606 may also be corrected taking into account the differential output signal of the gradient sensors 608, 610. According to the present disclosure, all transducer elements, the interconnecting electrically conductive leads 612 and the contact pads 614 are integrated on one common substrate 616 an are covered by a common protective layer and/or housing 618. In other words, the integrated magnetometer 600 combines a gradient sensor and a field sensor on one sensor chip.

In order to meet various demands regarding the channel width and number, by combining channels also channel widths being an integer multiple of the channel distance can be realized. In the simplest case, the output signals of neighboring channels can be mixed by directly connecting them. However, also individual half bridge signals or paired differential signals analog to a complete Wheatstone bridge can be generated.

In practice, larger channel widths and a smaller number of channels distributed over the length of the entire sensor array are often used to simplify evaluation. In such cases, the individual outputs of one or more integrated magnetometers can either be connected directly to each other. Alternatively, two separate groups of channels, each using one or more connected channel outputs, with opposite signal polarity can be used to generate a differential signal. In order to obtain the same or opposite signal polarities required for this purpose, one can either select the direction of the auxiliary magnetic fields required for the operation of MR sensors accordingly or also operate adjacent integrated magnetometers with the same or opposite supply voltages.

This solution allows the measurement of a high-resolution field signal and a gradient signal whose integral provides a reconstructed field signal with lower resolution but without interference. The advantages of both operating modes can thus be used together without disadvantages.

Furthermore, as can be seen from Fig. 6, the pin assignment of the sensor housing has been selected so that when using only one operating mode, it is possible to choose between the operating modes by soldering the terminals to a PCB rotated through 180°. In particular, the terminals belonging to the field sensors (UoH2, UoH1, GND, and VccH), which are encircled by solid lines, are arranged in a pattern corresponding to the terminals belonging to the gradient sensors (UoG2, UoG1, GND, and VccG), which are encircled with broken lines in Fig. 6.

In summary, the concept enables optimized signal quality and information retrieval. The integration of a field sensor with a gradient sensor does not increase the space requirement as compared to the gradient sensor taken alone. No different sensor types are required for field and gradient measurement. This simplifies and reduces the cost of sensor production, warehousing, and logistics. The pin assignment of the SMT package allows changing the operating mode without PCB modification. This simplifies the adaptation of sensor modules to customer requirements and increases the flexibility in development as well as in production.

The inventive concept is in particular suitable for magnetoresistive transducer elements, e. AMR or TMR transducers.

As mentioned above, the substrate 616 may comprise further electronic elements, such as protection components, e. g. ESD protection diodes, pre-amplifiers, and/or digitizer circuitry. According to the present disclosure, at least three magnetoresistive transducer elements are arranged in a way that both a high-resolution field signal and a robust gradient field signal is obtained, whose integral provides a reconstructed field signal with lower resolution but without interference. Moreover, a comparison of both signals gives information on the quality of the measurement.

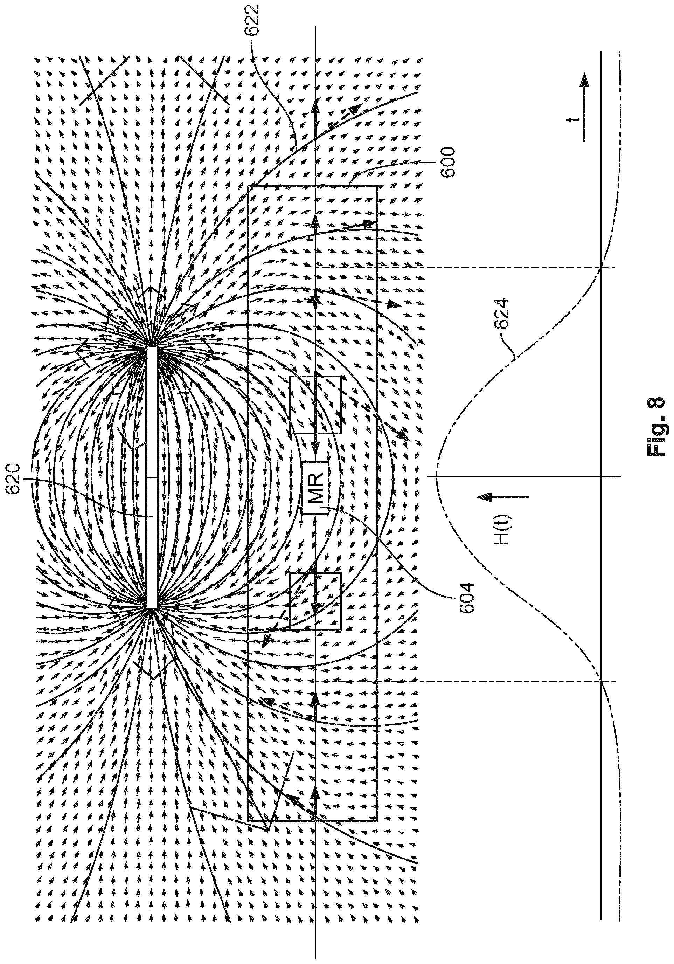

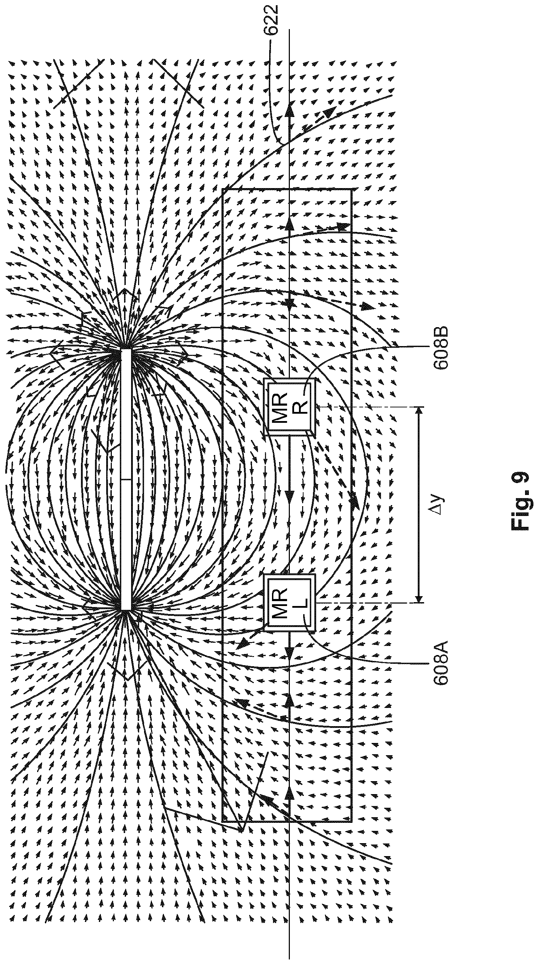

The operation of the integrated magnetometer 600 will be explained in more detail with respect to Figures 8 and 9.

Figure 8 shows the operational mode where only the magnetoresistive field sensors 604, 606 (only one sensor is visible in the cross-sectional view of Figure 8) are measuring the magnetic field of a moving magnetic source 620. Schematically, the magnetic flux lines 622 are shown with the tangential components (broken arrows) and the component along the sensitive plane of the magnetoresistive transducer element (i. e. along the y-direction, solid arrows).

As with the arrangement shown in Fig. 2, the maximum signal can be measured when the magnetic flux lines 622 are parallel to the sensitive plane of the magnetic field sensor 604, 606. The curve H(t) (reference numeral 624) has the H value of zero, when the magnetic flux lines are orthogonal to the sensitive plane of the magnetic field sensor 604.

As shown in Fig. 9, the magnetic gradient sensor 608 has two magnetoresistive transducer elements 608A, 608B, which are distanced apart by a distance Δy in scan direction. The gradient measurement yields an output signal which is the difference of the voltage measured across the magnetoresistive element 608B and the voltage measured across the other magnetoresistive element 608A. The magnetoresistive transducer elements 608A, 608B thus measure the local difference of the magnetic field distribution. The distance Δy determines the resolution in the scan direction and may for instance be 0.75 mm.

In summary, the present invention provides a device for the detection of ferro- or superparamagnetic structures on material surfaces using magnetic field sensitive sensor elements. These magnetic field sensitive sensor elements are assembled on a common carrier substrate. A spatially small sensor element array is responsive to homogeneous magnetic fields which generates a sensor signal which is initially approximatively proportional to a component of the magnetic field generated by the field generating structures. A second sensor element arrangement reacts to field differences between two respectively spatially small but spaced apart sensor elements. The sensor element arrangement responding to homogeneous fields is arranged in the space between the two sensor elements which form the sensor arrangement sensitive to local field differences. Specifically, the sensor elements each may comprise two resistors connected to a voltage divider arrangement and a magnetoresistive effect is used for signal generation. Further, separate supply voltage terminals may be provided for the sensor element arrays responsive to homogeneous fields and local field differences. An exemplary terminal assignment of the sensor package may be provided, which allows a change between a measurement of local field differences and a measurement of homogeneous fields by means of a 180° rotated placement on a carrier plate.

**REFERENCE NUMERALS**

| **Reference Numeral** | **Description** |
|---|---|
| 100 | Banknote |
| 102 | Magnetic source |
| 104 | Magnetic gradient sensor |
| 106 | Magnetic flux lines |
| 108 | Measurement signal curve δ(t) |
| 110 | Direction of movement |
| 112, 112A, 112B | Transducer element |
| 114 | Detected magnetic flux component |
| 116 | Magnetic field sensor |
| 118 | Transducer element |
| 120 | Measurement signal curve H(t) |
| 122, 122A, 122B | Transducer element |
| 400 | Three-channel magnetic gradient sensor |
| 412 | Transducer element |
| 424 | Electrically conductive lead |
| 426 | Central node |
| 428 | Contact pad |
| 500 | Three-channel magnetic field sensor |
| 512 | Transducer element |
| 524 | Electrically conductive lead |
| 526 | Central node |
| 528 | Contact pad |
| 600 | Integrated magnetometer |
| 602 | Channel distance |
| 604 | First magnetic field sensor; first transducer element |
| 606 | Second magnetic field sensor |
| 608 | First magnetic gradient sensor |
| 610 | Second magnetic gradient sensor |
| 612 | Electrically conductive lead |
| 614 | Contact pad |
| 616 | Substrate |
| 618 | Housing (or protective layer) |
| 620 | Magnetic source |
| 622 | Magnetic flux lines |
| 624 | Measurement curve |

## Claims

1. Integrated magnetometer (600) comprising:
at least one field sensor unit (604, 606) comprising a first transducer element (R_{H1}, R_{H2}; R_{H3}, R_{H4}) for generating, in response to a detected magnetic field, a first electrical output signal, and
at least one gradient sensor unit (608, 610) comprising at least a pair of second transducer elements (R_{G1}, R_{G2}; R_{G3}, R_{G4}) which are arranged to detect the magnetic field at two different locations and to generate, in response to the detected magnetic field, a second electrical output signal,
wherein said first and second transducer elements are formed on a common substrate (616) and are encompassed by a common protective layer and/or housing (618).

2. Integrated magnetometer according to claim 1, wherein the first transducer element (R_{H1}, R_{H2}; R_{H3}, R_{H4}) and/or the pair of second transducer elements (R_{G1}, R_{G2}; R_{G3}, R_{G4}) comprise at least one magnetoresistive element.

3. Integrated magnetometer according to claim 1 or 2, wherein the at least one first transducer element (R_{H1}, R_{H2}; R_{H3}, R_{H4}) is arranged between the two second transducer elements (R_{G1}, R_{G2}; R_{G3}, R_{G4}) of the at least one pair of second transducer elements, the first and second transducer elements being aligned to form a first transducer group.

4. Integrated magnetometer according to claim 3, wherein at least one further transducer group is arranged on the common substrate.

5. Integrated magnetometer according to one of the preceding claims, wherein the first transducer element (R_{H1}, R_{H2}; R_{H3}, R_{H4}) comprises two magnetoresistive elements, which are positioned adjacent to each other and which are electrically connected to form a half bridge.

6. Integrated magnetometer according to one of the preceding claims, wherein the two second transducer elements (R_{G1}, R_{G2}; R_{G3}, R_{G4}) of the at least one gradient sensor unit comprise one magnetoresistive element each, which are positioned distanced from each other and are electrically connected to form a half bridge.

7. Integrated magnetometer according to one of the preceding claims, further comprising a plurality of terminals for connecting the integrated magnetometer (600) to external components, wherein first terminals are connected to the field sensor unit and second terminals are connected to the gradient sensor unit, and wherein the first terminals are arranged in a pattern corresponding to a pattern of the second terminals turned by 180 degrees around a central axis of the substrate.

8. Integrated magnetometer according to one of the preceding claims, wherein the housing (618) is a surface mounted technology, SMT, compatible housing.

9. Integrated magnetometer according to one of the preceding claims, wherein the substrate (616) further comprises electronic components for protecting the sensor and/or electronic components for performing signal processing.

10. Method of detecting a magnetic field using at least one integrated magnetometer according to one of the preceding claims, wherein the method comprises the following steps:
measuring a magnetic field strength at a first position of the integrated magnetometer and generating an absolute output signal;
simultaneously, measuring the magnetic field strength at a second and a third position of the integrated magnetometer and calculating a differential signal;
evaluating the absolute signal and the differential signal to generate a combined output signal.

11. Method according to claim 10, wherein the magnetic field to be detected is movable with respect to the integrated magnetometer.

12. Method according to claim 10 or 11, wherein the absolute signal and the differential signal are compared to generate a quality signal indicative of the quality of the measurement.

13. Method according to claim 10 to 12, wherein the combined output signal is a reconstructed field signal which is corrected by cancelling interferences.

14. Method according to one of the claims 10 to 13, wherein the magnetic field to be detected is generated by a magnetic safety feature of a document.

15. Method according to one of the claims 10 to 14, wherein a plurality of groups formed by first and second transducer elements is used to measure a plurality of signal channels.
